# EUROPEAN PATENT SPECIFICATION

(11) **EP 2 183 799 B1**
(45) Date of publication and mention of the grant of the patent: **17.10.2018**
(21) Application number: 08795051.5
(22) Date of filing: 06.08.2008
(51) Int. Cl.: H01L 51/54

(54) **HIGH-PERFORMANCE BROADBAND OLED DEVICE**
HOCHLEISTUNGS-BREITBAND-OLED
DISPOSITIF OLED À LARGE BANDE À PERFORMANCE ÉLEVÉE

(30) Priority: 20.08.2007 US 841129
(43) Date of publication of application: 12.05.2010
(73) Proprietor: Global OLED Technology LLC, Herndon, VA 20171 (US)
(72) Inventor: SPINDLER, Jeffrey Paul, Rochester, New York 14650 (US); HATWAR, Tukaram Kisan, Rochester, New York 14650 (US); KLUBEK, Kevin Paul, Rochester, New York 14650 (US)
(74) Representative: Wibbelmann, Jobst
(86) International application number: PCT/US2008/009420
(87) International publication number: WO 2009/025724

(56) References cited:
- EP-A- 1 286 569
- EP-A- 1 775 334
- WO-A-2007/050334
- WO-A1-2008/094399
- US-A1- 2006 127 698
- US-A1- 2007 048 545
- US-A1- 2007 114 917
- US-A1- 2007 134 512

## Description

### FIELD OF THE INVENTION

The present invention relates to broadband light-producing OLED displays.

### BACKGROUND OF THE INVENTION

An organic light-emitting diode device, also called an OLED, commonly includes an anode, a cathode, and an organic electroluminescent (EL) unit sandwiched between the anode and the cathode. The organic EL unit includes at least a hole-transporting layer (HTL), a light-emitting layer (LEL), and an electron-transporting layer (ETL). OLEDs are attractive because of their low drive voltage, high luminance, wide viewing-angle, and capability for full color displays and for other applications. Tang et al. described this multilayer OLED in their U.S. Patent Nos. 4,769,292 and 4,885,211.

OLEDs can emit different colors, such as red, green, blue, or white, depending on the emitting property of its LEL. Recently, there is an increasing demand for broadband OLEDs to be incorporated into various applications, such as a solid-state lighting source, color display, or a full color display. By broadband emission, it is meant that an OLED emits sufficiently broad light throughout the visible spectrum so that such light can be used in conjunction with filters or color change modules to produce displays with at least two different colors or a full color display.

In order to achieve broadband emission from an OLED, more than one type of molecule has to be excited, because each type of molecule only emits light with a relatively narrow spectrum under normal conditions. A light-emitting layer having a host material and one or more luminescent dopant(s) can achieve light emission from both the host and the dopant(s) resulting in a broadband emission in the visible spectrum if the energy transfer from the host material to the dopant(s) is incomplete. However, to achieve a broadband OLED having a single light-emitting layer, the concentrations of light-emitting dopants must be carefully controlled, which produces manufacturing difficulties. A broadband OLED having two or more light-emitting layers can have better color and better luminance efficiency than a device with one light-emitting layer, and the variability tolerance for dopant concentration is higher. It has also been found that broadband OLEDs having two light-emitting layers are typically more stable than OLEDs having a single light-emitting layer.

A problem sometimes seen with multilayer broadband emitters is hue shift. As the current flowing through the device is varied, the relative contributions of the different emitting layers can also vary, leading to changes in hue with current changes. This is undesirable; it is desirable for a light-emitting device to give constant hue and merely change the luminance intensity with current changes.

In addition, there remains a need to improve efficiency of OLED devices while maintaining good broadband emission.

### SUMMARY OF THE INVENTION

It is therefore an object of the present invention to provide a broadband OLED device with improved efficiency and hue stability with current.

This object is achieved by an OLED device having two spaced electrodes, and comprising:
(a) a first light-emitting layer that produces green emission and includes:
   (i) an anthracene host selected from 2,9,10-triarylanthracene of formula B or 2,6,9,10-tetraarylanthracene of formula C: 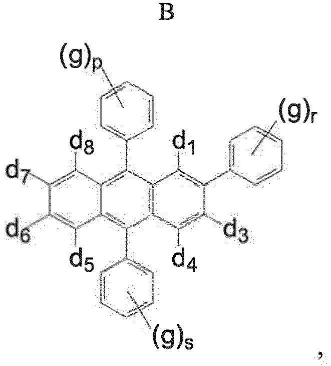 wherein d₁ and d₃-d₈ can be the same or different and each represents hydrogen or an independently selected substituent, and each g can be the same or different and each represents an independently selected substituent, provided that two substituents can combine to form a ring group and p, r, and s are independently 0-5, 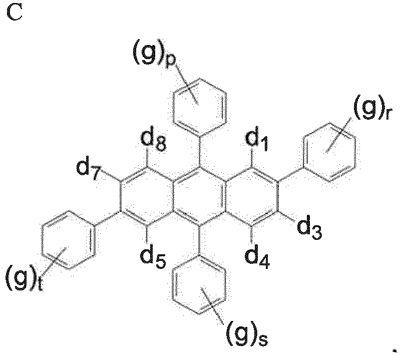 wherein d₁, d₃-d₅ and d₇-d₈ can be same or different and each represents hydrogen or an independently selected substituent, and each g can be the same or different and each represents an independently selected substituent, provided that two substituents can combine to form a ring group and p, r, s and t are independently 0-5; and
   (ii) a 2,6,9-triaminoanthracene light-emitting dopant of formula F or a 2,6,9,10-tetraaminoanthracene light emitting dopant of formula G: 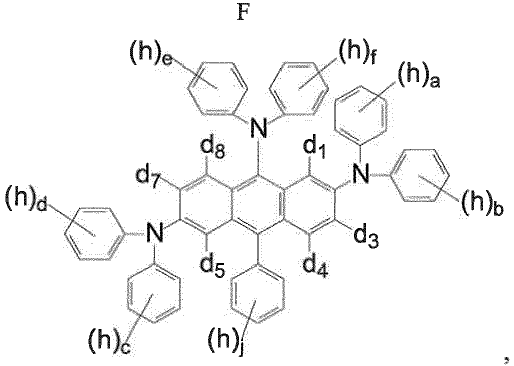 wherein d₁, d₃-d₅, and d₇-d₈ can be the same or different and each represents hydrogen or an independently selected substituent, and each h can be the same or different and each represents an independently selected substituent, provided that two substituents can combine to form a ring group, and a-f and j are independently 0-5, 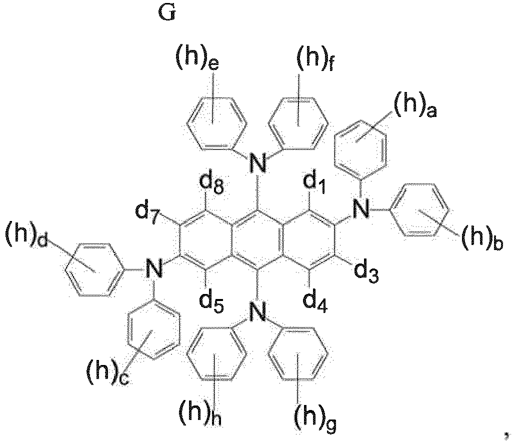 wherein d₁, d₃-d₅, and d₇-d₈ can be the same or different and each represents hydrogen or an independently selected substituent, and each h can be the same or different and each represents an independently selected substituent, provided that two substituents can combine to form a ring group, and a-h are independently 0-5; and
(b) a second light-emitting layer that produces red emission and includes a host and a red light-emitting dopant.

It is an advantage of this invention that it provides a broadband light-emitting structure with good efficiency and low voltage requirements. It is a further advantage of this invention that it also provides a broadband light-emitting structure that shows very little hue change with changing current. Further embodiments of the invention are set forth in the dependent claims as attached.

### BRIEF DESCRIPTION OF THE DRAWINGS

FIG. 1 shows one embodiment of an OLED device in accordance with this invention;
FIG. 2 shows another embodiment of an OLED device in accordance with this invention; and
FIG. 3 shows another embodiment of an OLED device in accordance with this invention.

Since device feature dimensions such as layer thicknesses are frequently in sub-micrometer ranges, the drawings are scaled for ease of visualization rather than dimensional accuracy.

### DETAILED DESCRIPTION OF THE INVENTION

The term "OLED device" is used in its art-recognized meaning of a display device including organic light-emitting diodes as pixels. It can mean a device having a single pixel. The term "OLED display" as used herein means an OLED device including a plurality of pixels, which can be of different colors. A color OLED device emits light of at least one color. The term "full color" is employed to describe display panels that are capable of emitting in the red, green, and blue regions of the visible spectrum and displaying images in any combination of hues. The red, green, and blue colors constitute the three primary colors from which all other colors can be generated by appropriate mixing. The term "hue" refers to the intensity profile of light emission within the visible spectrum, with different hues exhibiting visually discernible differences in color. The term "pixel" is employed in its art-recognized usage to designate an area of a display panel that is stimulated to emit light independently of other areas. It is recognized that in full color systems, several pixels of different colors will be used together to produce a wide range of colors, and a viewer can term such a group a single pixel. For the purposes of this discussion, such a group will be considered several different colored pixels. In accordance with this disclosure, broadband emission is light that has significant components in multiple portions of the visible spectrum, for example, red and green. Broadband emission can also include the situation where light is emitted in the red, green, and blue portions of the spectrum in order to produce white light. White light is that light that is perceived by a user as having a white color, or light that has an emission spectrum sufficient to be used in combination with color filters to produce a practical full color display.

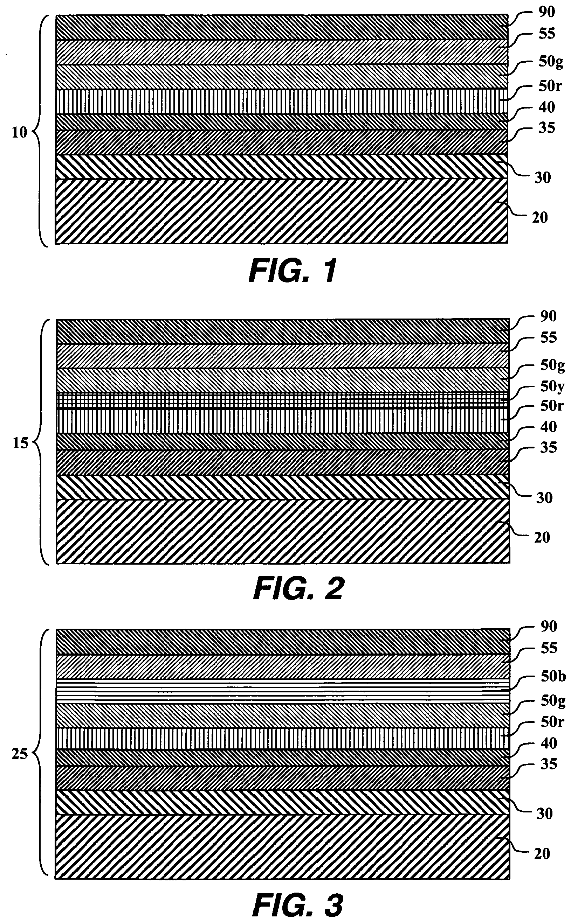

Turning now to FIG. 1, there is shown a cross-sectional view of a pixel of a broadband-emitting OLED device 10 according to one embodiment of the present invention. OLED device 10 includes a substrate 20, two spaced electrodes, which are anode 30 and cathode 90, and a first light-emitting layer that produces green emission, i.e. a green light-emitting layer 50g as defined in claim 1, and a second light-emitting layer that produces red emission, i.e. a red light-emitting layer 50r. The first light-emitting layer is in contact with the second light-emitting layer. Desirably, red light-emitting layer 50r is closer to anode 30 than green light-emitting layer 50g, but the practice of this invention is not limited to such an arrangement.

Light-emitting layers such as those described herein produce light in response to hole-electron recombination. Desired organic light-emitting materials can be deposited by any suitable way such as evaporation, sputtering, chemical vapor deposition, electrochemical process, or radiation thermal transfer from a donor material. The light-emitting layers in this invention include one or more host materials doped with one or more light-emitting guest compounds or dopants where light emission comes primarily from the dopant. A dopant is selected to produce color light having a particular spectrum and to have other desirable properties. Dopants are typically coated as 0.01 to 15% by weight into the host material.

First light-emitting layer 50g includes an anthracene host and a 2,6-diaminoanthracene light-emitting dopant. The anthracene host is
a 2,9,10-triarylanthracene of Formula B, which compounds constitute a class of useful host materials capable of supporting electroluminescence, and are particularly suitable for light emission of wavelengths longer than 400 nm, e.g., blue, green, yellow, orange or red.

| | |
|---|---|
| B | 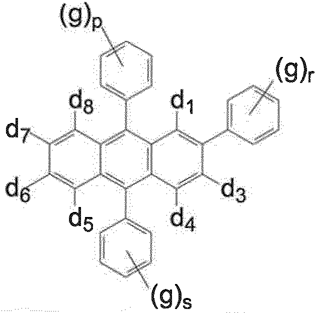 |

wherein d₁ and d₃-d₈ can be the same or different and each represents hydrogen or an independently selected substituent, and each g can be the same or different and each represents an independently selected substituent, provided that two substituents can combine to form a ring group and p, r, and s are independently 0-5.

Specific examples of useful 2,9,10-triarylanthracene materials for use as a host in a light-emitting layer include structures A10 and A11:

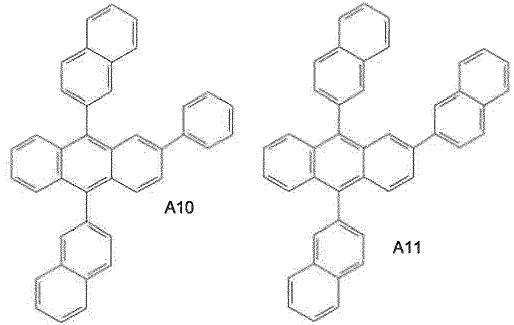

Further examples of 2,6,9-triarylanthracenes have been described by Klubek et al. in above-cited U.S. Patent Application Serial No. 11/668,515.

In another suitable embodiment, the anthracene host is a 2,6,9,10-tetrarylanthracenes of Formula C, which constitute a class of useful host materials capable of supporting electroluminescence, and are particularly suitable for light emission of wavelengths longer than 400 nm, e.g., blue, green, yellow, orange or red.

| | |
|---|---|
| C | 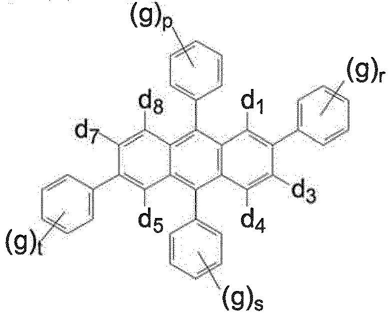 |

wherein d₁, d₃-d₅ and d₇-d₈ can be the same or different and each represents hydrogen or an independently selected substituent, and each g can be the same or different and each represents an independently selected substituent, provided that two substituents can combine to form a ring group and p, r, s and t are independently 0-5.

Specific examples of useful 2,6,9,10-tetraarylanthracene materials for use as a host in a light-emitting layer have been described by Klubek et al in above-cited U.S. Patent Application Serial No. 11/668,515.

Particularly useful in this invention are 2-aryl-9,10-bis(2-naphthyl)anthracenes, e.g. structures A10 and A11.
In addition to a host material as described above, first light-emitting layer 50g also includes
a 2,6,9-triaminoanthracene light-emitting dopant represented by formula F: 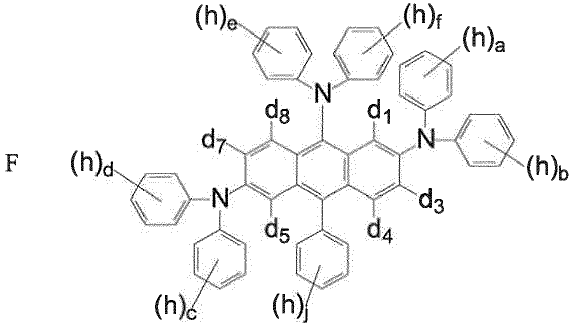 wherein d₁, d₃-d₅, and d₇-d₈ can be the same or different and each represents hydrogen or an independently selected substituent, and each h can be the same or different and each represents an independently selected substituent, provided that two substituents can combine to form a ring group, and a-f and j are independently 0-5.

Alternatively, the light-emitting dopant is a 2,6,9,10-tetraaminoanthracene light-emitting dopant represented by formula G: 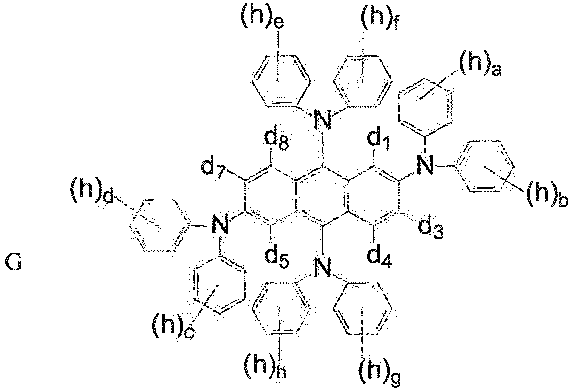 wherein d₁, d₃-d₅, and d₇-d₈ can be the same or different and each represents hydrogen or an independently selected substituent, and each h can be the same or different and each represents an independently selected substituent, provided that two substituents can combine to form a ring group, and a-h are independently 0-5. 2,6,9-triaminoanthracenes of structure F or 2,6,9,10-tetraaminoanthracenes of structure G have been described in detail by Klubek et al in above-cited U.S. Patent Application Serial No. 11/668,515. Diaminoanthracene dopants can be present in a concentration range of from 1% to 25% by volume, desirably 2% to 15% by volume, and usefully 3% to 10% by volume.

First light-emitting layer 50g can optionally include a small amount of a blue light-emitting dopant as a stabilizer. The presence of a blue light-emitting compound, which is a higher-energy dopant, provides greater luminance stability to the green emission of diaminoanthracene dopants, while maintaining good efficiency of the green light-emitting dopants. Blue light-emitting compounds can be those described below for blue light-emitting layer 50b. The blue light-emitting compound can be present in the concentration range of 0.2% to 10% by volume, and usefully from 1% to 5% by volume.

As a stabilizer, one can instead use a small amount of a second green light-emitting dopant. For example, one can use a small amount of a quinacridone compound, e.g. a compound of the following structure: 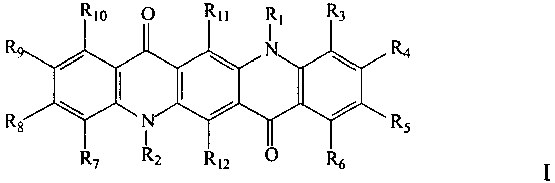 wherein substituent groups R₁ and R₂ are independently alkyl, alkoxyl, aryl, or heteroaryl; and substituent groups R₃ through R₁₂ are independently hydrogen, alkyl, alkoxyl, halogen, aryl, or heteroaryl, and adjacent substituent groups R₃ through R₁₀ can optionally be connected to form one or more ring systems, including fused aromatic and fused heteroaromatic rings, provided that the substituents are selected to provide an emission maximum between 510 nm and 540 nm. Alkyl, alkoxyl, aryl, heteroaryl, fused aromatic ring and fused heteroaromatic ring substituent groups can be further substituted. Some examples of useful quinacridones include those disclosed in U.S. Patent No. 5,593,788 and in U.S. Patent Application Publication 2004/0001969A1.

Examples of useful quinacridone green dopants include:

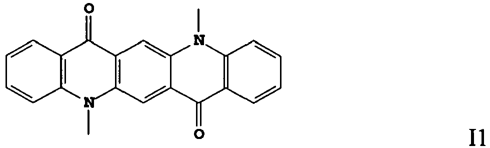

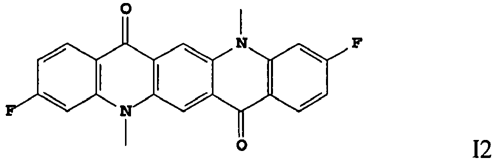

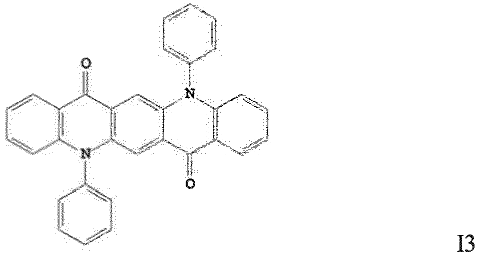

Second light-emitting layer 50r includes one or more host materials and one or more red light-emitting dopants. A red-light-emitting dopant can include a diindenoperylene compound of the following structure J: 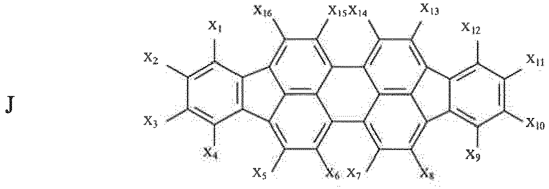 wherein:
X₁-X₁₆ are independently selected as hydrogen or substituents that include alkyl groups of from 1 to 24 carbon atoms; aryl or substituted aryl groups of from 5 to 20 carbon atoms; hydrocarbon groups containing 4 to 24 carbon atoms that complete one or more fused aromatic rings or ring systems; or halogen, provided that the substituents are selected to provide an emission maximum between 560 nm and 640 nm.

Illustrative examples of useful red dopants of this class are shown by Hatwar et al. in commonly-assigned U.S. Patent No. 7,247,394.

Some other red dopants belong to the DCM class of dyes represented by Formula K: 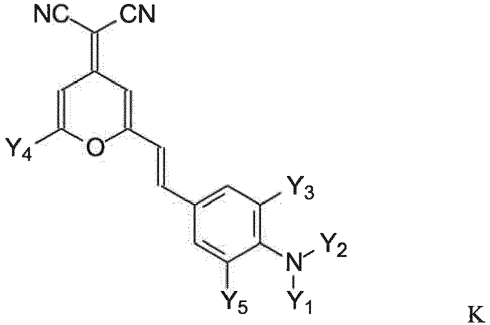 wherein Y₁ - Y₅ represent one or more groups independently selected from: hydro, alkyl, substituted alkyl, aryl, or substituted aryl; Y₁ - Y₅ independently include acyclic groups or can be joined pairwise to form one or more fused rings; provided that Y₃ and Y₅ do not together form a fused ring. Structures of particularly useful dopants of the DCM class are shown by Ricks et al. in commonly-assigned U.S. Patent No. 7,252,893.

The host material in second light-emitting layer 50r includes a hole-transporting material. Hole-transporting materials useful as hosts in light-emitting layers are well known to include compounds such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel et al. in U.S. Patent 3,180,730. Other suitable triarylamines substituted with one or more vinyl radicals and/or including at least one active hydrogen-containing group are disclosed by Brantley et al. in U.S. Patents 3,567,450 and 3,658,520.

A more preferred class of aromatic tertiary amines are those which include at least two aromatic tertiary amine moieties as described in U.S. Patents 4,720,432 and 5,061,569. Such compounds include those represented by structural Formula L. 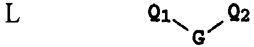 wherein:
Q₁ and Q₂ are independently selected aromatic tertiary amine moieties; and
G is a linking group such as an arylene, cycloalkylene, or alkylene group of a carbon to carbon bond.

One class of such aromatic tertiary amines are the tetraaryldiamines. Desirable tetraaryldiamines include two diarylamino groups linked through an arylene group. Useful tetraaryldiamines include those represented by Formula M. 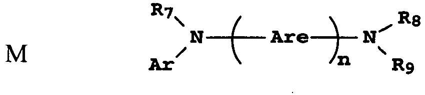 wherein:
each Are is an independently selected arylene group, such as a phenylene or anthracene moiety;
n is an integer of from 1 to 4; and
Ar, R₇, R₈, and R₉ are independently selected aryl groups.

The various alkyl, alkylene, aryl, and arylene moieties of the foregoing structural Formulae L and M can each in turn be substituted. Typical substituents include alkyl groups, alkoxy groups, aryl groups, aryloxy groups, and halogens such as fluoride, chloride, and bromide. The various alkyl and alkylene moieties typically contain from 1 to about 6 carbon atoms. The cycloalkyl moieties can contain from 3 to about 10 carbon atoms, but typically contain five, six, or seven carbon atoms--e.g., cyclopentyl, cyclohexyl, and cycloheptyl ring structures. The aryl and arylene moieties are usually phenyl and phenylene moieties. Usefully, the hole-transporting host material is an N,N,N',N'-tetraarylbenzidine, wherein the Are of Formula M represents a phenylene group and n equals 2.

Second light-emitting layer 50r can further include a 9,10-diarylanthracene derivative, as described above, as a co-host. The 9,10-diarylanthracene derivative can be present in the concentration range of from 1% to 95% by volume, and usefully from 25% to 75% by volume.

Second light-emitting layer 50r can further include a yellow light-emitting dopant. A light-emitting yellow dopant can include a compound of the following structures: 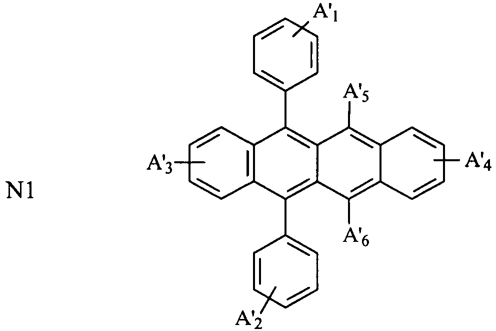 or 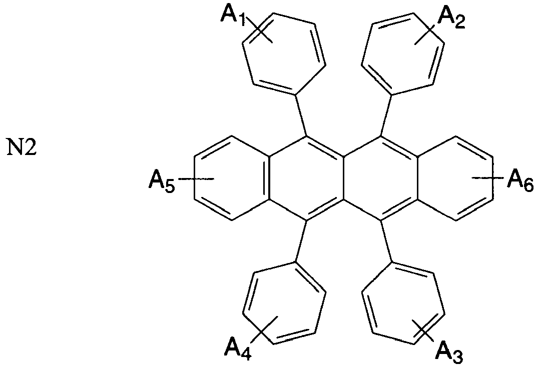 wherein A₁-A₆ and A'₁-A'₆ represent one or more substituents on each ring and where each substituent is individually selected from one of the following:
Category 1: hydrogen, or alkyl of from 1 to 24 carbon atoms;
Category 2: aryl or substituted aryl of from 5 to 20 carbon atoms;
Category 3: hydrocarbon containing 4 to 24 carbon atoms, completing a fused aromatic ring or ring system;
Category 4: heteroaryl or substituted heteroaryl of from 5 to 24 carbon atoms such as thiazolyl, furyl, thienyl, pyridyl, quinolinyl or other heterocyclic systems, which are bonded via a single bond, or complete a fused heteroaromatic ring system;
Category 5: alkoxylamino, alkylamino, or arylamino of from 1 to 24 carbon atoms; or
Category 6: fluoro or cyano.

Examples of particularly useful yellow dopants are shown by Ricks et al in commonly-assigned U.S. Patent No. 7,252,893.

Other OLED device layers that can be used in this invention have been well described in the art, and OLED device 10, and other such devices described herein, can include layers commonly used for such devices. In addition to the layers and materials described below, useful materials have been described in detail elsewhere, e.g. by Klubek et al. in above-cited U.S. Patent Application Serial No. 11/668,515. OLED devices are commonly formed on a substrate, e.g. OLED substrate 20. Such substrates have been well-described in the art. A bottom electrode is formed over OLED substrate 20 and is most commonly configured as an anode 30, although the practice of this invention is not limited to this configuration. When EL emission is viewed through the anode, the anode should be transparent, or substantially transparent, to the emission of interest. Common transparent anode materials used in the present invention are indium-tin oxide (ITO), indium-zinc oxide (IZO) and tin oxide, but other metal oxides can work including, but not limited to, aluminum- or indium-doped zinc oxide, magnesium-indium oxide, and nickel-tungsten oxide. In addition to these oxides, metal nitrides such as gallium nitride, and metal selenides such as zinc selenide, and metal sulfides such as zinc sulfide, can be used as the anode. For applications where EL emission is viewed
only through the cathode electrode, the transmissive characteristics of the anode are immaterial and many conductive materials can be used, regardless if transparent, opaque, or reflective. Example conductors for the present invention include, but are not limited to, gold, iridium, molybdenum, palladium, and platinum. Typical anode materials, transmissive or otherwise, have a work function no less than 4.0 eV. Desired anode materials can be deposited by any suitable way such as evaporation, sputtering, chemical vapor deposition, or electrochemical process. Anode materials can be patterned using well-known photolithographic processes.

A hole-transporting layer 40 can be formed and disposed over the anode. Hole-transporting layer 40 can include any hole-transporting material useful in OLED devices, many examples of which are known to those skilled in the art. Some examples of useful hole-transporting materials were described above as hole-transporting host materials, but hole-transporting layer 40 is not limited to these. Desired hole-transporting materials can be deposited by any suitable way such as evaporation, sputtering, chemical vapor deposition, electrochemical process, thermal transfer, or laser thermal transfer from a donor material.

An electron-transporting layer 55 can include any electron-transporting material useful in OLED devices, many examples of which are known to those skilled in the art. Electron-transporting layer 55 can contain one or more metal chelated oxinoid compounds, including chelates of oxine itself, also commonly referred to as 8-quinolinol or 8-hydroxyquinoline. Other electron-transporting materials include various butadiene derivatives as disclosed in U.S. Patent No. 4,356,429 and various heterocyclic optical brighteners as described in U.S. Patent No. 4,539,507. Benzazoles, oxadiazoles, triazoles, pyridinethiadiazoles, triazines, phenanthroline derivatives, and some silole derivatives are also useful electron-transporting materials. Other electron-transporting materials have been described by Klubek et al in above-cited U.S. Patent Application Serial No. 11/668,515.

An upper electrode most commonly configured as a cathode 90 is formed over the electron-transporting layer 55. If the device is top-emitting, the electrode must be transparent or nearly transparent. For such applications, metals must be thin (preferably less than 25 nm) or one must use transparent conductive oxides (e.g. indium-tin oxide, indium-zinc oxide), or a combination of these materials. Optically transparent cathodes have been described in more detail in U.S. Patent No. 5,776,623. Cathode materials can be deposited by evaporation, sputtering, or chemical vapor deposition. When needed, patterning can be achieved through many well known methods including, but not limited to, through-mask deposition, integral shadow masking as described in U.S. Patent No. 5,276,380 and EP 0 732 868, laser ablation, and selective chemical vapor deposition.

OLED device 10 can include other layers as well. For example, a hole-injecting layer 35 can be formed over the anode, as described in U.S. Patent No. 4,720,432, U.S. Patent No. 6,208,075, EP 0 891 121 A1, and EP 1 029 909 A1. Also useful as disclosed by Son et al., in U.S. Patent No. 6,720,573, is a material of the general structure:

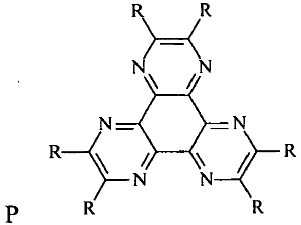

Other hole-injecting materials have been described by Klubek et al in above-cited U.S. Patent Application Serial No. 11/668,515.

An electron-injecting layer, such as alkaline or alkaline earth metals, alkali halide salts, or alkaline or alkaline earth metal doped organic layers, can also be present between cathode 90 and electron-transporting layer 55. Other electron-injecting materials have been described by Klubek et al in above-cited U.S. Patent Application Serial No. 11/668,515.

Turning now to FIG. 2, there is shown another embodiment of an OLED device in accordance with this invention. OLED device 15 includes the layers of OLED device 10 and further includes a third light-emitting layer, e.g. yellow light-emitting layer 50y, which is in contact with first and second light-emitting layers 50g and 50r, and which produces yellow light emission. Light-emitting layer 50y includes one or more host materials and a yellow light-emitting dopant. Yellow light-emitting dopants have been described above. Desirably, the yellow light-emitting dopant that produces the yellow light emission is a rubrene derivative, that is, a compound of structure N2 above. The host can include a 9,10-diarylanthracene, as described above, an N,N,N',N'-tetraarylbenzidine, as described above, or a mixture thereof as co-hosts.

Turning now to FIG. 3, there is shown another embodiment of an OLED device in accordance with this invention. OLED device 25 includes the layers of OLED device 10 and further includes a third light-emitting layer, e.g. blue light-emitting layer 50b, which is in contact with first light-emitting layer 50g, and which produces blue light emission. Light-emitting layer 50b includes one or more host materials and a blue light-emitting dopant. The host can include a 9,10-diarylanthracene, as described above, or a mixture of a 9,10-diarylanthracene with an N,N,N',N'-tetraarylbenzidine, as described above. The blue-light-emitting compound can include a bis(azinyl)azene boron complex compound of the structure Q: 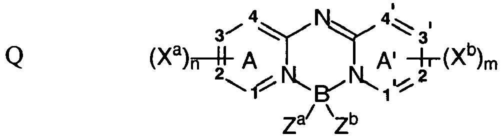 wherein:
A and A' represent independent azine ring systems corresponding to 6-membered aromatic ring systems containing at least one nitrogen;
(X^{a})ₙ and (X^{b})ₘ represent one or more independently selected substituents and include acyclic substituents or are joined to form a ring fused to A or A';
m and n are independently 0 to 4;
Z^{a} and Z^{b} are independently selected substituents;
1, 2, 3, 4, 1', 2', 3', and 4' are independently selected as either carbon or nitrogen atoms; and
provided that X^{a}, X^{b}, Z^{a}, and Z^{b}, 1, 2, 3, 4, 1', 2', 3', and 4' are selected to provide blue luminescence.

Some examples of the above class of dopants are disclosed by Ricks et al in commonly-assigned U.S. Patent No. 7,252,893.

Another class of blue dopants is the perylene class. Particularly useful blue dopants of the perylene class include perylene and tetra-t-butylperylene (TBP).

Another class of blue dopants includes blue-emitting derivatives of such styrylarenes and distyrylarenes as distyrylbenzene, styrylbiphenyl, and distyrylbiphenyl, including compounds described in U.S. Patent No. 5,121,029, and U.S. Patent Application Publication No. 2006/0093856 by Helber et al. Among such derivatives that provide blue luminescence, particularly useful are those substituted with diarylamino groups. Examples include bis[2-[4-[N,N-diarylamino]phenyl]vinyl]-benzenes of the general structure R1 shown below:

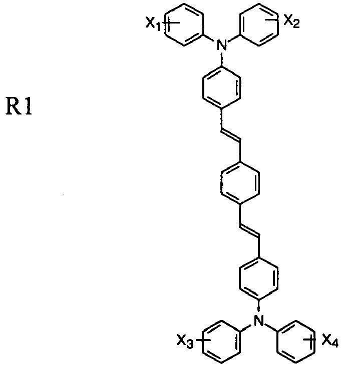

[N,N-diarylamino][2-[4-[N,N-diarylamino]phenyl]vinyl]biphenyls of the general structure R2 shown below: 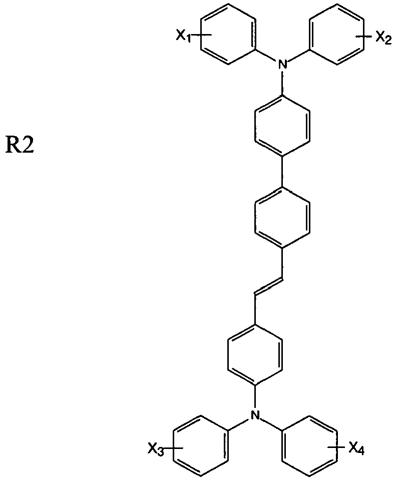 and bis[2-[4-[N,N-diarylamino]phenyl]vinyl]biphenyls of the general structure R3 shown below:

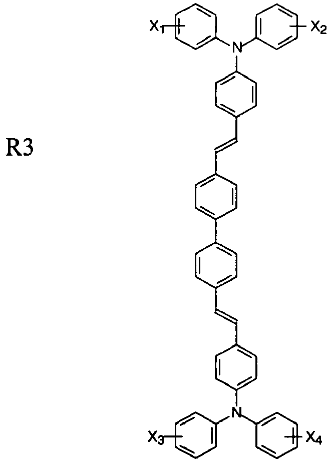

In Formulas R1 to R3, X₁ - X₄ can be the same or different, and individually represent one or more substituents such as alkyl, aryl, fused aryl, halo, or cyano. In a preferred embodiment, X₁ - X₄ are individually alkyl groups, each containing from one to about ten carbon atoms. A particularly preferred blue dopant of this class is disclosed by Ricks et al in commonly-assigned U.S. Patent No. 7,252,893.

The invention and its advantages can be better appreciated by the following comparative examples. Comparative examples 2 to 10 are useful for understanding this invention, while Example 1 is a non-inventive OLED device example for comparison purposes. The layers described as vacuum-deposited were deposited by evaporation from heated boats under a vacuum of approximately 10⁻⁶ Torr. After deposition of the OLED layers each device was then transferred to a dry box for encapsulation. The OLED has an emission area of 10 mm². The devices were tested by applying a current of 20 mA/cm² across electrodes, except that the fade stability was tested at 80 mA/cm². The results from Examples 1 to 10 are given in Table 1.

### Example 1 (Comparative)

1. On top of a clean glass substrate, indium tin oxide (ITO) was deposited by sputtering to form a transparent electrode of 60 nm thickness.
2. The above-prepared ITO surface was treated with a plasma oxygen etch.
3. The above-prepared substrate was further treated by vacuum-depositing a 10 nm layer of hexacyanohexaazatriphenylene (CHATP) as a hole-injecting layer (HIL). 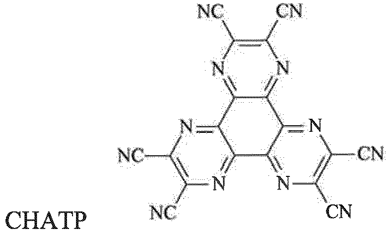
4. The above-prepared substrate was further treated by vacuum-depositing a 10 nm layer of 4,4'-bis[N-(1-naphthyl)-N-phenylamino]biphenyl (NPB) as a hole-transporting layer (HTL).
5. The above-prepared substrate was further treated by vacuum-depositing a 20 nm red light-emitting layer including 94.5% NPB as a host and 5% diphenyltetra-t-butylrubrene (PTBR) as a yellow-emitting dopant with 0.5% dibenzo{[*f,f'*]-4,4'7,7'-tetraphenyl]diindeno-[1,2,3-*cd*:1',2',3'-*lm*]perylene (TPDBP) as a red emitting dopant. 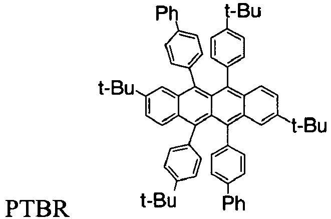
6. The above-prepared substrate was further treated by vacuum-depositing a 40 nm green light-emitting layer including 84.5% 2-phenyl-9,10-bis(2-naphthyl)anthracene (PBNA) and 15% NPB as co-hosts, with 0.5% diphenylquinacridone (DPQ) as green emitting dopant.
7. The above-prepared substrate was further treated by vacuum-depositing a 20 nm blue light-emitting layer including 99% PBNA host with 1% BEP as blue-emitting dopant. 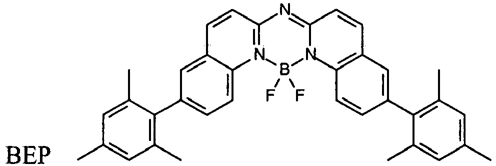
8. A 40 nm mixed electron-transporting layer was vacuum-deposited, including 49% 4,7-diphenyl-1,10-phenanthroline (also known as bathophen or Bphen) and 49% tris(8-quinolinolato)aluminum (III) (ALQ) as co-hosts, with 2% Li metal.
9. A 100 nm layer of aluminum was evaporatively deposited onto the substrate to form a cathode layer.

### Example 2 (Illustrative)

An OLED device was constructed as described above for Example 1 except that Step 6 was as follows:
6. The above-prepared substrate was further treated by vacuum-depositing a 40 nm green light-emitting layer including 90% PBNA as host and 10% 2,6-bis(diphenylamino)-9,10-diphenylanthracene as green emitting dopant.

### Example 3 (Illustrative)

1. On top of a clean glass substrate, ITO was deposited by sputtering to form a transparent electrode of 60 nm thickness.
2. The above-prepared ITO surface was treated with a plasma oxygen etch.
3. The above-prepared substrate was further treated by vacuum-depositing a 10 nm layer of CHATP as an HIL.
4. The above-prepared substrate was further treated by vacuum-depositing a 10 nm layer of NPB as an HTL.
5. The above-prepared substrate was further treated by vacuum-depositing a 20 nm red light-emitting layer including 94.5% of NPB as a host and 5% PTBR as a yellow-emitting dopant with 0.5% TPDBP as a red emitting dopant.
6. The above-prepared substrate was further treated by vacuum-depositing a 40 nm green light-emitting layer including 89% PBNA as a host, 10% 2,6-bis(diphenylamino)-9,10-diphenylanthracene as green emitting dopant, with 1% BEP as a stabilizer.
7. A 40 nm mixed electron-transporting layer was vacuum-deposited, including 49% Bphen, 49% ALQ, with 2% Li metal.
8. A 100 nm layer of aluminum was evaporatively deposited onto the substrate to form a cathode layer.

### Example 4 (Illustrative)

An OLED device was constructed as described above for Example 3 except that Step 6 was as follows:
6. The above-prepared substrate was further treated by vacuum-depositing a 40 nm green light-emitting layer including 89.7% PBNA as a host, 10% 2,6-bis(diphenylamino)-9,10-diphenylanthracene as green emitting dopant, and 0.3% diphenylquinacridone (DPQ) as a stabilizer.

### Example 5 (Illustrative)

An OLED device was constructed as described above for Example 3 except that Step 5 was as follows:
5. The above-prepared substrate was further treated by vacuum-depositing a 20 nm red light-emitting layer including 99.5% of NPB as a host with 0.5% TPDBP as a red emitting dopant.

### Example 6 (Illustrative)

An OLED device was constructed as described above for Example 3 except that Step 5 was as follows:
5. The above-prepared substrate was further treated by vacuum-depositing a 20 nm red light-emitting layer including 69.5% NPB and 30% 9-(1-naphthyl)-10-(2-naphthyl)anthracene (NNA) as co-hosts with 0.5% TPDBP as a red emitting dopant.

### Example 7 (Illustrative)

An OLED device was constructed as described above for Example 6 except that 39.5% NPB and 60% NNA were used as co-hosts in Step 5.

### Example 8 (Illustrative)

1. On top of a clean glass substrate, ITO was deposited by sputtering to form a transparent electrode of 60 nm thickness.
2. The above-prepared ITO surface was treated with a plasma oxygen etch.
3. The above-prepared substrate was further treated by vacuum-depositing a 10 nm layer of CHATP as an HIL.
4. The above-prepared substrate was further treated by vacuum-depositing a 10 nm layer of NPB as an HTL.
5. The above-prepared substrate was further treated by vacuum-depositing a 20 nm red light-emitting layer including 74.5% of NPB and 25% NNA as co-hosts with 0.5% TPDBP as a red emitting dopant.
6. The above-prepared substrate was further treated by vacuum-depositing a 4 nm yellow light-emitting layer including 74% NPB and 24% NNA as co-hosts with 2% yellow-orange emitting dopant PTBR.
7. The above-prepared substrate was further treated by vacuum-depositing a 40 nm green light-emitting layer including 91.5% PBNA as host and 7.5% 2,6-bis(diphenylamino)-9,10-diphenylanthracene as green emitting dopant, with 1% BEP as a stabilizer.
8. A 40 nm mixed electron-transporting layer was vacuum-deposited, including 49% Bphen, 49% ALQ, with 2% Li metal.
9. A 100 nm layer of aluminum was evaporatively deposited onto the substrate to form a cathode layer.

### Example 9 (Illustrative)

An OLED device was constructed as described above for Example 8 except that 24% NPB and 74% NNA were used in Step 6.

### Example 10 (Illustrative)

An OLED device was constructed as described above for Example 8 except that 91.5% 2,9,10-tris(2-naphthyl)anthracene was used instead of PBNA as the host in Step 7.

The results of testing these examples are shown in Table 1, below. The inventive examples (2 through 10) show, relative to the comparative example, improved luminance efficiency, quantum efficiency, and resistance to hue change with varying current. They further show similar voltage requirements.

**Table 1 - Device data measured at 20 mA/cm² (except fade data); illustrative**

| Device # | Voltage | Lum Efficiency (cd/A) | CIEx | CIEy | QE% | Color Change (delta CIE 0.01 to 100 mA/cm²) | Room Temp Fade Stability @80mA/cm² (hrs to 50%) |
|---|---|---|---|---|---|---|---|
| Example 1 (Comparative) | 3.8 | 12.0 | 0.329 | 0.526 | 4.3 | 0.12 | 1189 |
| Example 2 | 3.8 | 11.7 | 0.430 | 0.523 | 4.9 | 0.01 | 713 |
| Example 3 | 3.9 | 11.2 | 0.432 | 0.524 | 4.8 | 0.02 | 1058 |
| Example 4 | 4.3 | 10.6 | 0.372 | 0.580 | 3.9 | 0.04 | 1761 |
| Example 5 | 4.0 | 14.8 | 0.337 | 0.598 | 5.2 | 0.02 | 624 |
| Example 6 | 4.0 | 14.5 | 0.342 | 0.594 | 5.2 | 0.01 | 752 |
| Example 7 | 4.2 | 14.4 | 0.338 | 0.597 | 5.1 | 0.02 | 861 |
| Example 8 | 3.8 | 18.8 | 0.354 | 0.590 | 6.0 | 0.02 | 689 |
| Example 9 | 3.9 | 17.2 | 0.367 | 0.581 | 5.6 | 0.04 | 965 |
| Example 10 | 4.0 | 20.2 | 0.382 | 0.574 | 6.6 | 0.01 | 538 |

### PARTS LIST

- 10: OLED device
- 15: OLED device
- 20: substrate
- 25: OLED device
- 30: anode
- 35: hole-injecting layer
- 40: hole-transporting layer
- 50y: yellow light-emitting layer
- 50b: blue light-emitting layer
- 50r: red light-emitting layer
- 50g: green light-emitting layer
- 55: electron-transporting layer
- 90: cathode

## Claims

1. An OLED device having two spaced electrodes, and comprising:
(a) a first light-emitting layer that produces green emission and includes:
(i) an anthracene host selected from 2,9,10-triarylanthracene of formula B or 2,6,9,10-tetraarylanthracene of formula C: 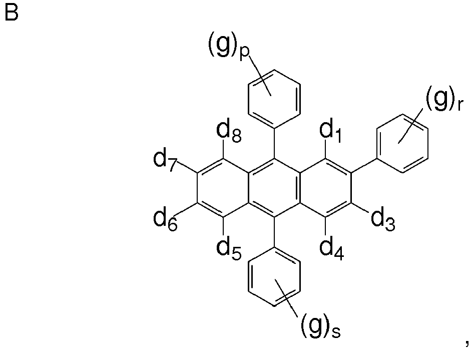 wherein d₁ and d₃-d₈ can be the same or different and each represents hydrogen or an independently selected substituent, and each g can be the same or different and each represents an independently selected substituent, provided that two substituents can combine to form a ring group and p, r, and s are independently 0-5, 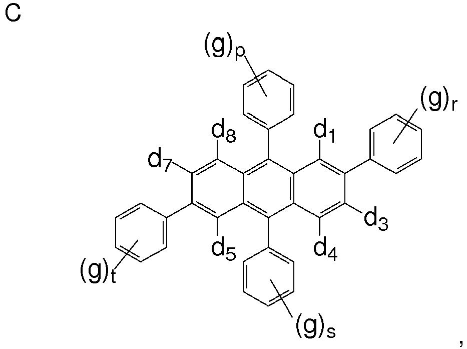 wherein d₁, d₃-d₅ and d₇-d₈ can be same or different and each represents hydrogen or an independently selected substituent, and each g can be the same or different and each represents an independently selected substituent, provided that two substituents can combine to form a ring group and p, r, s and t are independently 0-5; and
(ii) a 2,6,9-triaminoanthracene light-emitting dopant of formula F or a 2, 6, 9, 10-tetraaminoanthracene light-emitting dopant of formula G: 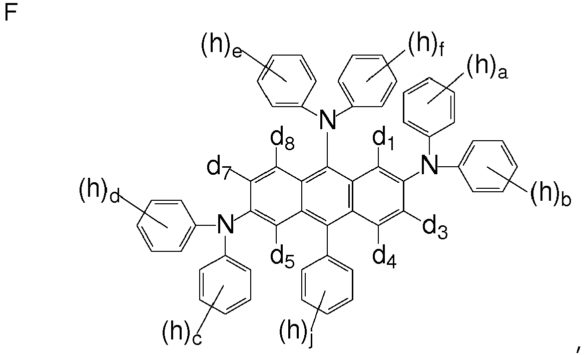 wherein d₁, d₃-d₅, and d₇-d₈ can be the same or different and each represents hydrogen or an independently selected substituent, and each h can be the same or different and each represents an independently selected substituent, provided that two substituents can combine to form a ring group, and a-f and j are independently 0-5, 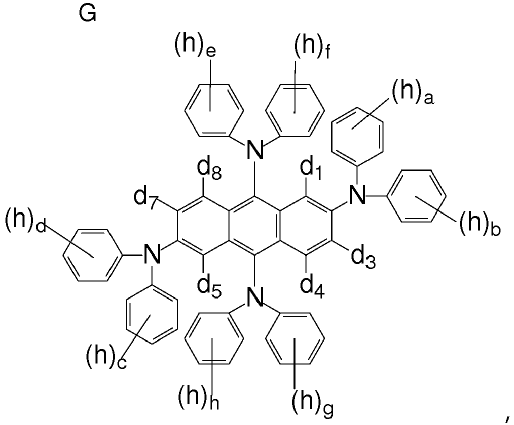 wherein d₁, d₃-d₅, and d₇-d₈ can be the same or different and each represents hydrogen or an independently selected substituent, and each h can be the same or different and each represents an independently selected substituent, provided that two substituents can combine to form a ring group, and a-h are independently 0-5; and
(b) a second light-emitting layer that produces red emission and includes a host and a red light-emitting dopant.

2. The OLED device of claim 1 wherein the first light-emitting layer further includes a blue light-emitting dopant.

3. The OLED device of claim 1 wherein the first light-emitting layer is in contact with the second light-emitting layer.

4. The OLED device of claim 1 wherein the red light-emitting dopant is a diindenoperylene compound.

5. The OLED device of claim 1 wherein the second light-emitting layer host is an aromatic amine.

6. The OLED device of claim 5 wherein the aromatic amine is an N,N,N',N'-tetraarylbenzidine.

7. The OLED device of claim 5 wherein the second light-emitting layer further includes a 9,10-diarylanthracene derivative co-host.

8. The OLED device of claim 1 wherein the second light-emitting layer further includes a yellow light-emitting dopant.

9. The OLED device of claim 1 further including a third light-emitting layer in contact with the first and second light-emitting layers and producing yellow light emission.

10. The OLED device of claim 9 wherein the yellow light emission is produced by a rubrene derivative dopant.

11. The OLED device of claim 10 wherein the yellow light-emitting layer further includes a mixture of an N,N,N',N'-tetraarylbenzidine and a 9,10-diarylanthracene as co-hosts.

12. The OLED device of claim 1 further including a third light-emitting layer in contact with the first light-emitting layer and producing blue light emission.

## Patentansprüche

1. OLED-Vorrichtung mit zwei abgetrennten Elektroden, und umfassend:
(a) eine erste lichtemittierende Schicht, die grüne Emission erzeugt und einschließt:
(i) einen Anthracen-Wirt, ausgewählt aus 2,9,10-Triarylanthracen der Formel B oder 2,6,9,10-Tetraarylanthracen der Formel C: 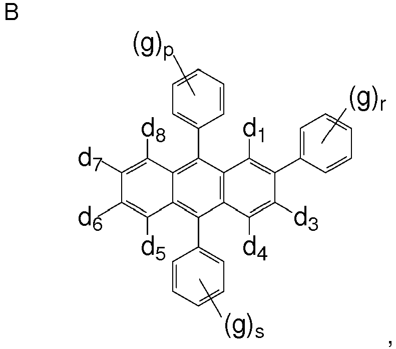 worin d₁ und d₃-d₈ gleich oder verschieden sein können und jeweils ein Wasserstoff oder einen unabhängig ausgewählten Substituenten darstellen, und jedes g kann gleich oder verschieden sein und jeweils einen unabhängig ausgewählten Substituenten darstellen, vorausgesetzt, dass zwei Substituenten miteinander unter Bildung einer Ringgruppe kombinieren können und p, r und s unabhängig voneinander 0-5 sind, 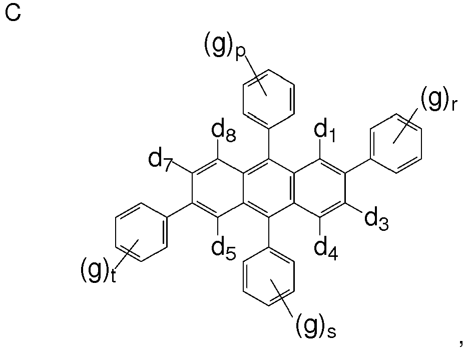 worin d₁, d₃-d₅ und d₇-d₈ gleich oder verschieden sein können und jeweils ein Wasserstoff oder einen unabhängig ausgewählten Substituenten darstellen, und jedes g kann gleich oder verschieden sein und jeweils einen unabhängig ausgewählten Substituenten darstellen, vorausgesetzt, dass zwei Substituenten miteinander unter Bildung einer Ringgruppe kombinieren können und p, r und s unabhängig voneinander 0-5 sind; und
(ii) ein 2,6,9-Triaminoanthracen-lichteimittierende Dotiersubstanz der Formel F oder ein 2,6,9,10-Tetraaminoanthracen-lichtemittierende Dotiersubstanz der Formel G: 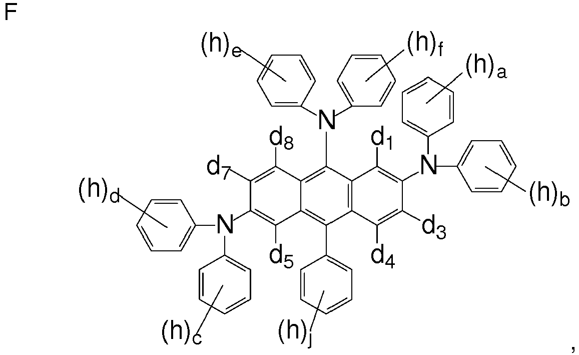 worin d₁, d₃-d₅ und d₇-d₈ gleich oder verschieden sein können und jeweils ein Wasserstoff oder einen unabhängig ausgewählten Substituenten darstellen, und jedes h kann gleich oder verschieden sein und jeweils einen unabhängig ausgewählten Substituenten darstellen, vorausgesetzt, dass zwei Substituenten miteinander unter Bildung einer Ringgruppe kombinieren können, und a-f und j unabhängig voneinander 0-5 sind, 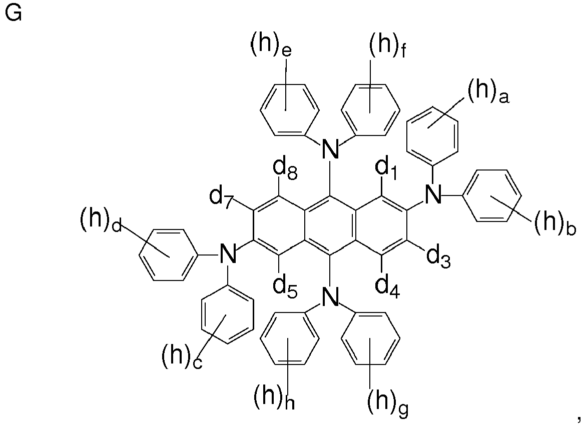 worin d₁, d₃-d₅ und d₇-d₈ gleich oder verschieden sein können und jeweils ein Wasserstoff oder einen unabhängig ausgewählten Substituenten darstellen, und jedes h kann gleich oder verschieden sein und jeweils einen unabhängig ausgewählten Substituenten darstellen, vorausgesetzt, dass zwei Substituenten miteinander unter Bildung einer Ringgruppe kombinieren können, und a-h unabhängig voneinander 0-5 sind; und
(b) eine zweite lichtemittierende Schicht, die rote Emission erzeugt und einen Wirt und eine rotes Licht emittierende Dotiersubstanz einschließt.

2. OLED-Vorrichtung nach Anspruch 1, worin die erste lichtemittierende Schicht weiterhin ein blaues Licht emittiere Dotiersubstanz einschließt.

3. OLED-Vorrichtung nach Anspruch 1, worin die erste lichtemittierende Schicht in Kontakt mit der zweiten lichtemittierenden Schicht ist.

4. OLED-Vorrichtung nach Anspruch 1, worin die rotes Licht emittierende Dotiersubstanz eine Diindenoperylen-Verbindung ist.

5. OLED-Vorrichtung nach Anspruch 1, worin der zweite lichtemittierende Schichtwirt ein aromatisches Amin ist.

6. OLED-Vorrichtung nach Anspruch 5, worin das aromatische Amin ein N,N,N',N'-Tetraarylbenzidin ist.

7. OLED-Vorrichtung nach Anspruch 5, worin die zweite lichtemittierende Schicht weiterhin ein 9,10-Diarylanthracen-Derivat-Co-Wirt umfasst.

8. OLED-Vorrichtung nach Anspruch 1, worin die zweite lichtemittierende Schicht weiterhin eine gelbes Licht emittierende Dotiersubstanz umfasst.

9. OLED-Vorrichtung nach Anspruch 1, weiterhin umfassend eine dritte lichtemittierende Schicht in Kontakt mi den ersten und zweiten lichtemittierenden Schichten und eine gelbes Licht Emission erzeugend.

10. OLED-Vorrichtung nach Anspruch 9, worin die gelbe Lichtemission durch eine Rubren-Derivat-Dotiersubstanz erzeugt wird.

11. OLED-Vorrichtung nach Anspruch 10, wobei die gelbes Licht emittierende Schicht weiterhin eine Mischung eines N,N,N',N'-Tetraarylbenzidins und eines 9,10-Diarylanthracens als Co-Wirte einschließt.

12. OLED-Vorrichtung nach Anspruch 1, weiterhin umfassend eine dritte lichtemittierende Schicht in Kontakt mit der ersten lichtemittierenden Schicht und eine blaues Licht Emission.

## Revendications

1. Dispositif OLED ayant deux électrodes espacées, et comprenant :
(a) une première couche électroluminescente qui produit de l'émission verte et comprend :
(i) un hôte d'anthracène sélectionné à partir de 2, 9, 10-triaryl-anthracène de formule B ou 2, 6, 9, 10-tétraarylanthracène de formule C : 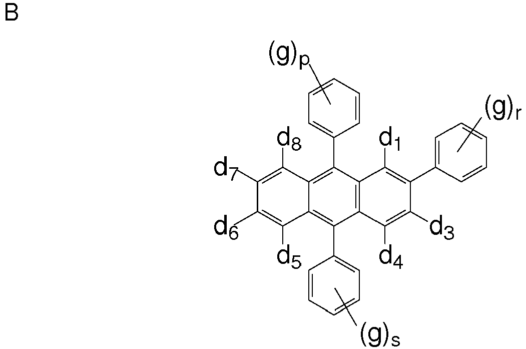 dans laquelle d₁ et d₃-d₈ peuvent être les mêmes ou différents, et chacun représente l'hydrogène ou un substituant sélectionné indépendamment, et chaque g peut être le même ou différent, et chacun représente un substituant sélectionné indépendamment, à condition que les deux substituants puissent être combinés pour former un groupe en anneau et p, r et s sont indépendamment 0-5, 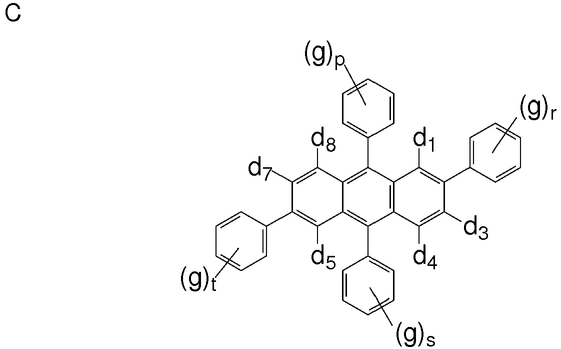 dans laquelle d₁, d₃-d₅ et d₇-d₈ peuvent être les mêmes ou différents, et chacun représente l'hydrogène ou un substituant sélectionné indépendamment, et chaque g peut être le même ou différent, et chacun représente un substituant sélectionné indépendamment, à condition que les deux substituants puissent être combinés pour former un groupe en anneau et p, r, s et t sont indépendamment 0-5 ; et
(ii) un dopant électroluminescent à base de 2, 6, 9-triaminoanthracène de formule F ou un dopant électroluminescent à base de 2, 6, 9, 10-tétraarylanthracène de formule G : 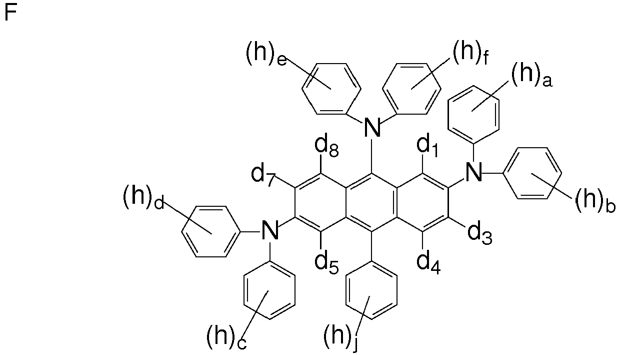 dans laquelle d₁, d₃-d₅ et d₇-d₈ peuvent être les mêmes ou différents, et chacun représente l'hydrogène ou un substituant sélectionné indépendamment, et chaque h peut être le même ou différent, et chacun représente un substituant sélectionné indépendamment, à condition que les deux substituants puissent être combinés pour former un groupe en anneau et a-f et j sont indépendamment 0-5 : 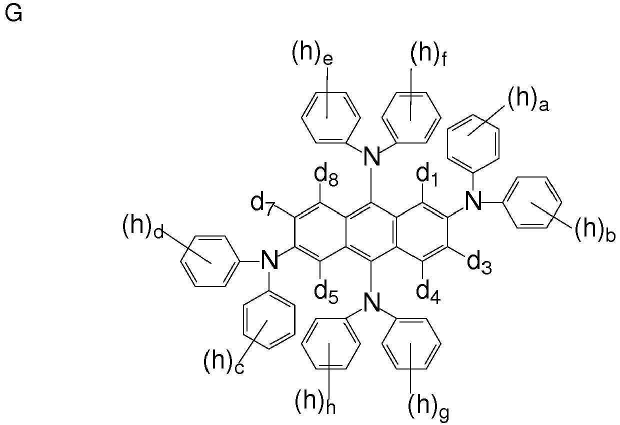 dans laquelle d₁, d₃-d₅ et d₇-d₈ peuvent être les mêmes ou différents, et chacun représente l'hydrogène ou un substituant sélectionné indépendamment, et chaque h peut être le même ou différent, et chacun représente un substituant sélectionné indépendamment, à condition que les deux substituants puissent être combinés pour former un groupe en anneau, et a-h sont indépendamment 0-5 ; et
(b) une deuxième couche électroluminescente qui produit une émission rouge et comprend un hôte et un dopant électroluminescent rouge.

2. Dispositif OLED selon la revendication 1, dans lequel la première couche électroluminescente comprend en outre un dopant électroluminescent bleu.

3. Dispositif OLED selon la revendication 1, dans lequel la première couche électroluminescente est en contact avec la deuxième couche électroluminescente.

4. Dispositif OLED selon la revendication 1, dans lequel le dopant électroluminescent rouge est un composé de diindénopérylène.

5. Dispositif OLED selon la revendication 1, dans lequel le second hôte de couche électroluminescente est une amine aromatique.

6. Dispositif OLED selon la revendication 5, dans lequel l'amine aromatique est une N, N, N', N'-tétraarylbenzidine.

7. Dispositif OLED selon la revendication 5, dans lequel la deuxième couche électroluminescente comprend en outre un co-hôte dérivé de 9, 10-diarylanthracène.

8. Dispositif OLED selon la revendication 1, dans lequel la deuxième couche électroluminescente comprend en outre un dopant électroluminescent jaune.

9. Dispositif OLED selon la revendication 1, comprenant en outre une troisième couche électroluminescente en contact avec les première et deuxième couches électroluminescentes et produisant une émission de lumière jaune.

10. Dispositif OLED selon la revendication 9, dans lequel l'émission de lumière jaune est produite par un dopant dérivé de rubrène.

11. Dispositif OLED selon la revendication 10, dans lequel la couche électroluminescente jaune comprend en outre un mélange d'une N, N, N', N'-tétraarylbenzidine et un 9, 10-diarylanthracène en tant que co-hôtes.

12. Dispositif OLED selon la revendication 1, comprenant en outre une troisième couche électroluminescente en contact avec la première couche électroluminescente et produisant une émission de lumière bleue.
